# EUROPÄISCHE PATENTSCHRIFT

(11) **EP 1 155 445 B1**
(45) Veröffentlichungstag und Bekanntmachung des Hinweises auf die Patenterteilung: **06.07.2005**
(21) Anmeldenummer: 00914028.6
(22) Anmeldetag: 11.02.2000
(51) Int. Cl.: H01L 21/60, H01L 21/56, C23C 18/44

(54) **VERFAHREN ZUR HERSTELLUNG ELEKTRISCH LEITENDER VERBINDUNGEN**
METHOD FOR PRODUCING ELECTRICALLY CONDUCTIVE CONNECTIONS
PROCEDE DE REALISATION DE LIAISONS ELECTROCONDUCTRICES

(30) Priorität: 11.02.1999 DE 19905807
(43) Veröffentlichungstag der Anmeldung: 21.11.2001
(73) Patentinhaber: KSW Microtec AG, 01099 Dresden (DE)
(72) Erfinder: SEIDOWSKI, Thomas, D-01157 Dresden (DE); KRIEBEL, Frank, D-01896 Lichtenberg (DE); SADOWSKI, Günter, D-01445 Radebeul (DE)
(74) Vertreter: Heyner, Klaus, Dr.-Ing.
(86) Internationale Anmeldenummer: PCT/DE2000/000417
(87) Internationale Veröffentlichungsnummer: WO 2000/048242

(56) Entgegenhaltungen:
- EP-A- 0 308 971
- EP-A- 0 387 066
- EP-A- 0 930 645
- WO-A-96/05614
- DE-A- 19 631 565
- US-A- 4 749 120
- US-A- 5 579 573
- PATENT ABSTRACTS OF JAPAN vol. 011, no. 353 (C-457), 18. November 1987 (1987-11-18) & JP 62 124280 A (ISHIHARA YAKUHIN KK), 5. Juni 1987 (1987-06-05)

## Beschreibung

Die Erfindung betrifft ein Verfahren zur Herstellung elektrisch leitender Verbindungen zwischen einzelnen Kontakten elektronischer Bauelemente, die auf elektrisch leitende Leitbahnstrukturen, die auf den verschiedensten Substraten ausgebildet sind, aufgesetzt und miteinander kontaktiert werden. Das Verfahren kann mit verschiedensten elektronischen Bauelementen, insbesondere mit Halbleiterchips oder elektronischen Sensoren auf den verschiedensten Substraten eingesetzt werden. So kann eine Kontaktierung der entsprechend ausgebildeten elektronischen Bauelemente z.B. auf Leiterplatten, Chipkarten oder auf flexiblen Trägermaterialien erfolgen.

Anlehnend an die bekannte Flip-Chip-Technik kann auf die Löttechnik oder andere bekannte Bondverfahren, mit deren hinlänglich bekannten Nachteilen verzichtet werden.

So ist z.B. in DE 196 39 934 A1 ein Verfahren zur Montage eines Halbleiterchips auf einem Verdrahtungssubstrat beschrieben, bei der die Kontaktierung, also eine elektrisch leitende Verbindung zwischen den Anschlußflecken bzw. Kontakten eines Halbleiterchips mit einer auf einem Substrat ausgebildeten Leitbahnstruktur unter Verwendung eines isotrop elektrisch leitenden Klebstoffes erreicht werden kann. Der elektrisch leitende Klebstoff wird lokal gezielt auf der Leitbahnstruktur, den jeweiligen Kontakten des Halbleiterchips zugeordnet, aufgebracht. An den Kontakten des Halbleiterchips sind bei diesem Beispiel unter Wärmeeinwirkung veränderliche Anschlußpodeste, üblicherweise als Bumps bezeichnet, ausgebildet, die in den elektrisch leitenden Klebstoff eingedrückt und während einer Wärmebehandlung der elektrisch leitende Klebstoff ausgehärtet wird, so daß eine solide und feste Verbindung des Halbleiterchips erreicht werden kann.

Bei einer solchen Vorgehensweise ist es aber problematisch, den elektrisch leitenden Klebstoff entsprechend dosiert und lokal definiert auf ein bereits mit der Leitbahnstruktur versehenes Substrat aufzubringen, wobei hierfür normalerweise auf herkömmliche Siebdruckverfahren zurückgegriffen wird, die jedoch bezüglich des Klebstoffverbrauches nachteilig sind, da in den verwendeten Sieben immer Reste verbleiben, die nicht ausgenutzt werden können.

Außerdem wird für das Aushärten, der bekannten isotropen elektrisch leitenden Klebstoffe eine bestimmte Energiemenge benötigt. Da aber für die Wärmebehandlung nur begrenzte maximale Temperaturen angewendet werden dürfen, schlägt sich dieses in einer entsprechend langen Taktzeit, die für die Aushärtung eines solchen Klebstoffes erforderlich ist, nieder. Demzufolge verlängert sich die entsprechende Taktzeit und der erforderliche Energiebedarf ist entsprechend hoch.

In einer Modifizierung der Flip-Chip-Technik werden an dem Chip Anschlußpodeste aus Gold verwendet, die mit einem sogenannten anisotrop elektrisch leitenden Klebstoff elektrisch leitend mit einer Leitbahnstruktur verbunden werden. In einem solchen anisotropen elektrisch leitendem Klebstoff sind elektrisch leitende Partikel regellos verteilt enthalten, deren Größe jedoch so klein gehalten ist, daß dieser Klebstoff an sich keine elektrisch leitenden Eigenschaften besitzt. Werden aber die Gold-Anschlußpodeste durch den nicht ausgehärteten anisotropen elektrisch leitenden Klebstoff auf die Leitbahnstruktur gedrückt, befinden sich solche elektrisch leitenden Partikel zwischen den Oberflächen der Leitbahnstruktur und den Anschlußpodesten, so daß über die elektrisch leitenden Partikel die elektrisch leitende Verbindung herstellbar ist. Als elektrisch leitende Partikel kommen reine Edelmetalle, wie z.B. Palladium oder Silber oder Gold zum Einsatz. Es sind aber auch mit Gold und Nickel beschichtete Kunststoffkügelchen bekannt. Letztere verfügen wegen der relativ großen zur Verfügung stehenden Oberfläche und den elastischen Eigenschaften des verwendeten Kunststoffmaterials über günstige Verbindungseigenschaften, da zum einen eine entsprechende große Oberfläche zur Verfügung steht und die elastischen Rückstellkräfte dazu führen, daß zwischen Leitbahn und Oberfläche des Anschlußpodestes eine innige Berührung erhalten bleibt. Solche metallbeschichteten Kunststoffkügelchen sind aber entsprechend teuer und es wird nur ein relativ kleiner Teil, der in einem anisotrop elektrisch leitenden Klebstoff enthaltenden Kugeln für die elektrisch leitende Verbindung ausgenutzt.

Ein weiteres Problem, das bei den bisher bekannten Verfahren nur unzulänglich gelöst worden ist, besteht darin, daß der Übergangswiderstand durch auf metallischen Leitbahnstrukturen ausgebildeten Oxid- oder organischen Schutzschichten vergrößert wird. Dieses Problem wirkt sich insbesondere bei Leitbahnstrukturen aus Kupfer und ganz besonders bei Leitbahnstrukturen aus Aluminium negativ aus. So bildet sich bereits mit relativ geringen Sauerstoffanteilen auf Aluminium eine relativ dichte Aluminiumoxidschicht aus, die außerdem relativ stabil ist. Solche Aluminiumoxidschichten verändern zusätzlich ihre Eigenschaften und dabei insbesondere ihre Leitfähigkeit bei wechselnden Umgebungsbedingungen sehr schnell, so daß es hierdurch zusätzlich zu Funktionseinschränkungen eines so kontaktieren elektronischen Bauelementes kommen kann. Ähnlich wirken auf Metallen aufgebrachte Schutzschichten als organischer Anlaufschutz, die mit einer oder mehreren Atomlage(n) auf die Oberfläche aufgebracht sind.

Des Weiteren ist in DE 196 31 565 A1 ein Verfahren zum Herstellen von Palladiumkontaktbumps auf Halbleiterschaltungsträgern_beschrieben, wobei diese Palladiumbumps durch stromloses metallisieren mit Palladium gebildet werden.

In WO 96/05614 A1 ist die Möglichkeit des kontaktierens von Halbleiterbauelementen mit elektrisch nicht leitenden Adhäsiven in der sogenannten Flip-Chip-Technologie beschrieben.

Aus US 3,915,780 kann ein System zur Montage und Einkapselung von integrierten Schaltkreisen, die auf einem polymeren Film angeordnet sind, entnommen werden. Dabei wird ein entsprechender mit Halbleiterbauelementen bestückter Polymerfilm beidseitig mit einer Epoxidschicht eingefasst und entsprechend eingekapselt.

In EP 0 387 066 A1 ist ein Verfahren zum Verbinden von Schaltkreisen mittels adhäsiver Filme offenbart.

Es ist daher Aufgabe der Erfindung, eine Möglichkeit vorzuschlagen, mit der sehr einfach, kostengünstig und mit hoher Übertragungssicherheit eine leitende Verbindung zwischen den Kontakten elektronischer Bauelemente und Leitbahnstrukturen aus einem elektrisch leitenden Material erreicht wird.

Erfindungsgemäß wird diese Aufgabe mit den Merkmalen des Anspruchs 1 gelöst. Vorteilhafte Ausgestaltungsformen und Weiterbildungen der Erfindung, ergeben sich mit den in den untergeordneten Ansprüchen genannten Merkmalen.

Bei dem erfindungsgemäßen Verfahren werden elektronische Bauelemente verwendet, deren einzelne Kontakte mit Anschlußpodesten (Bumps) versehen werden, die so dimensioniert sind, daß die Anschlußpodeste über die Grundfläche des elektronischen Bauteiles hervorstehen. Günstigerweise können die Anschlußpodeste durch stromlose Abscheidung hergestellt werden, wobei es besonders günstig ist, eine stromlose Abscheidung von Palladium durchzuführen.

Dabei kann die stromlose Abscheidung von Palladium mit einem wäßrigen Elektrolyten, indem eine Palladiumverbindung in einer Konzentration von 0,005 bis 0,15 mol/l, ein zur Reduktion von Palladiumionen geeignetes Reduktionsmittel und Komplexbildner enthalten sind, erfolgen.

Da reines Palladium aber die Eigenschaft aufweist, daß es in Verbindung mit Zinn oder anderen Lotbestandteilen beim Löten oder auch bei einfachem Kontakt, bei erhöhten Temperaturen zur Ausbildung intermetallischer Phasen durch Umwandlungsvorgänge kommt, die die Haftfestigkeit und Zuverlässigkeit der elektrisch leitenden Verbindungen beeinträchtigen, was insbesondere bei der sehr reinen Abscheidung von Palladium bei Verwendung von Methansäure als Reduktionsmittel auftritt, ist es vorteilhaft, nicht reines Palladium, sondern eine Palladiumlegierung stromlos abzuscheiden.

Hierzu können im Elektrolyten zusätzlich Nickel- und/oder Cobalt-Verbindungen in gelöster Form enthalten sein.

Als geeigneter Komplexbildner für die stromlose Abscheidung können im Elektrolyten unsubstituierte Amine und zusätzlich ein oder mehrere in Wasser lösliche Amine mit α- oder β-ständigen Carboxyl- oder Carbonylgruppen in einer Gesamtkonzentration von 0,01 bis 0,8 mol/l enthalten sein.

Solche Amine können als lösliche Mono-, Di- oder Tri-amine oder höhere Amine einzeln oder Gemische davon in einer Gesamtkonzentration von 0,05 bis 2 mol/l enthalten sein.

Als reduzierende Mittel können neben der bereits erwähnten Methansäure auch Verbindungen aus den Gruppen der Hypophosphorsäure, der Bornitride, der Aldehyde oder deren Derivate dieser Verbindungen im Elektrolyten enthalten sein. Außerdem können zusätzlich Netzmittel im Konzentrationsbereich von 0,01 bis 0,1 Masse-% im Elektrolyten enthalten sein.

Vorteilhaft ist es außerdem, wenn Stabilisatoren zugesetzt sind, wobei hierfür lösliche Schwermetallverbindungen aus der Gruppe der Metalle Kupfer, Thallium, Wismut, Antimon, Blei oder Indium in Konzentrationen von 1 x 10⁻⁵ bis 3 x 10⁻² mol/l eingesetzt werden können.

Der pH-Wert sollte im Bereich zwischen 4 und 10, bevorzugt im Bereich zwischen 8,1 und 8,3 eingestellt werden und die stromlose Abscheidung bei Temperaturen im Bereich zwischen 40 und 95 °C, bevorzugt zwischen 65 und 68 °C durchgeführt werden.

Vor der stromlosen Abscheidung von Palladium bzw. einer bereits erwähnten Palladiumlegierung können die Anschlußpodeste gereinigt und aktiviert werden, wobei vor der stromlosen Abscheidung als erstes eine Reinigung mit einer tensidhaltigen wäßrigen Lösung durchgeführt wird, an die sich eine Tauchreinigung in Phosphorsäure anschließen kann. Im Nachgang dazu wird eine Behandlung in einer alkalischen, handelsüblichen Zinkatlösung durchgeführt, woraufhin die gebildete Zinkschicht mit Salpetersäure abgeätzt wird.

Die stromlose Abscheidung von Palladium oder einer Palladiumlegierung kann in diesem Stadium aber auch nach einer erneuten Zinkatbehandlung durchgeführt werden.

Bei der stromlosen Abscheidung ist es besonders vorteilhaft, daß lediglich ein einziger Elektrolyt verwendet wird und die eigentliche stromlose Abscheidung in einem einzigen technologischen Schritt durchgeführt werden kann, wobei auf die übliche Verwendung von zusätzlichen Masken verzichtet werden kann.

Durch die stromlose Abscheidung der erwähnten Palladium-Nickel bzw. Palladium-Cobalt-Legierungen kann auch bei relativ geringem Anteil dieser Legierungskomponenten eine hohe Stabilität gegenüber Lotbestandteilen und Zinn, auch bei höheren Temperaturen erreicht werden, was sich auch vorteilhaft bei der Herstellung der elektrisch leitenden Verbindung, wie sie z.B. in der Flip-Chip-Technik angewandt wird, auswirkt.

Die mit einer Palladiumlegierung ausgebildeten Anschlußpodeste weisen eine sehr gute Lötfähigkeit, hohe Haftfestigkeit und einen relativ geringen Übergangswiderstand auch zu elektrisch leitenden Klebern auf.

Ein so vorbereitetes elektronisches Bauteil wird dann auf eine auf einem Substrat ausgebildete Leitbahnstruktur aus einem Metall oder elektrisch leitender Paste mit einer bestimmten, vorgebbaren Kraft aufgepreßt, so daß beide unmittelbar miteinander in Berührung stehen.

Eine dauerhafte Verbindung des elektronischen Bauteiles auf dem Substrat, bei elektrisch leitender Verbindung mit der Leitbahnstruktur, kann einmal mit einem Stoff oder Stoffgemisch erreicht werden, der/das zwischen Bauteil und Substrat aufgebracht und im Anschluß daran, z.B. durch Energiezufuhr aushärtet und sich dabei sein Volumen verringert, so daß zusätzlich zu den Adhäsionskräften weitere Zugkräfte, mit denen das kontaktierte Bauteil an der Leitbahnstruktur gehalten wird, wirken. Es kann sich also bei dieser Alternative um einen herkömmlichen Klebstoff handeln, der keine elektrisch leitenden Eigenschaften aufweisen muß und demzufolge gegenüber den isotrop oder anisotrop elektrisch leitenden Klebstoffen wesentlich kostengünstiger sein kann.

Eine andere Möglichkeit zur dauerhaften Befestigung des elektronischen Bauelementes auf einem Substrat, besteht darin, daß dieses mit einer Folie überdeckt wird, die beispielsweise beim Erkalten ihr Volumen verringert, so daß das/die elektronische Baueelement(e), das/die zwischen Substrat und Folie eingeschlossen ist/sind, sicher gehalten werden kann/können. Hierbei kann ein geeignetes Folienmaterial mit entsprechender Dicke verwendet werden. Günstigerweise können aus der Verpackungsindustrie bekannte Polymere Schrumpffolien verwendet werden.

Günstig ist es außerdem, wenn mit dem Stoff bzw. Klebstoff oder der Polymerfolie ein gasdichter Abschluß zumindest im Kontaktbereich der Anschlußpodeste mit der Leitbahnstruktur erreicht wird, so daß atmosphärische Umwelteinflüsse weitestgehend ausgeschlossen werden können.

Ganz besonders vorteilhaft ist es, wenn die Oberfläche der Anschlußpodeste, die in unmittelbaren Kontakt mit der Leitbahnstruktur gebracht wird, strukturiert, z.B. als Randüberhöhung ausgebildet wird. Diese strukturierte Oberfläche kann sich sehr gut beim Einpressen mit dem Material der Leitbahnstruktur verzahnen und es wird gleichzeitig dadurch erreicht, daß eine sich eventuell gebildete Oberflächenoxidschicht mit Sicherheit so weit aufgerissen wird, daß eine elektrisch leitende Verbindung mit nahezu konstantem elektrischem Widerstand erreicht wird. Eine solche Verbindung kann eine Kaltpreßschweißverbindung zwischen Metallen sein. Dieser Sachverhalt trifft auch auf die bisher besonders problematische Verwendung von Leitbahnstrukturen aus Aluminium zu.

Die bisher aufgetretenen Probleme bei der elektrisch leitenden Verbindung zu elektrisch leitenden Pasten oder über solche, die infolge von Einschlüssen elektrisch leitender Partikel in elektrisch nicht leitendem Harz zu verzeichnen waren, können mit der Erfindung auch bei der Kontaktierung elektronischer Bauelemente mit Leitbahnstrukturen aus einer elektrisch leitenden Paste beseitigt werden.

Das erfindungsgemäße Verfahren kann auf den verschiedensten Substraten, also auch auf ebenen flächigen Gebilden durchgeführt werden, so daß eine Bestückung von Leiterplatten und die Herstellung von den verschiedensten Chip-Karten oder elektronische Etiketten, als eine mögliche Ausführungsform von Remote-Coupling-Cards, auf einfache und kostengünstige Art und Weise möglich ist. Es können aber auch Substrate aus flexiblen Materialien, wie z.B. flexible Kunststoffe, Papier, Karton, Gewebe oder Gewirke mit entsprechenden elektronischen Bauelementen bestückt werden, die für die verschiedensten Anwendungsbereiche und -gebiete geeignet sind. Sollen mit der erfindungsgemäßen Lösung beispielsweise Chip-Karten hergestellt werden, kann auf einem ebenen flächigen Element die Leitbahnstruktur als Antenne wirkende Struktur, z.B. ein Dipol oder eine Spule, wobei eine Spule mindestens eine Windung aufweist, aufgebracht sein. Diese Spule kann dann für die kontaktlose Übermittlung von Daten und/oder Energie genutzt werden, wie dies bei den sogenannten Remote-Coupling-Cards der Fall ist.

Mit der erfindungsgemäßen Lösung können die Herstellungskosten durch Verringerung des erforderlichen Zeitvolumens und durch gleichzeitige Verringerung der erforderlichen Energie, gegenüber den bisher üblichen Bestückungsverfahren gesenkt werden.

Nachfolgend soll die Erfindung beispielhaft erläutert werden.

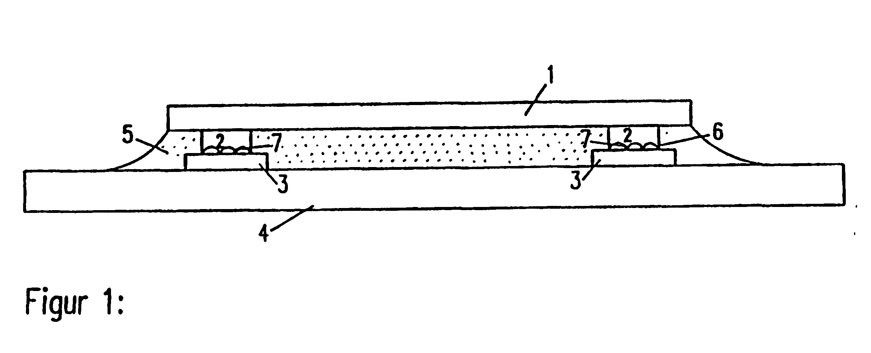

Dabei zeigt Figur 1, in einer Schnittdarstellung, einen Teil einer Chip-Karte.

Auf dem Kartenträger als Substrat 4, aus einem Kunststoff, z.B. PVC, ist mit bekannten Verfahren eine Leitbahnstruktur 3, hier aus Aluminium, aufgebracht worden. Auf die vom Halbleiterchip als elektronisches Bauelement 1 in Anspruch genommene Fläche, wird eine relativ dünne Schicht eines Klebstoffes 5 aufgebracht.

Der Halbleiterchip wurde an seinen Kontaktstellen mit Anschlußpodesten 2, durch stromlose Abscheidung von Palladium versehen. Dabei ist in der Figur 1 deutlich erkennbar, daß die Anschlußpodeste 2 über die Grundfläche des Halbleiterchips, als elektronisches Bauelement 1, hinausragen und die durch den Klebstoff 5 gebildete Schicht unmittelbar auf die Oberfläche der Aluminiumleitbahnstruktur 3 gepreßte Oberfläche der Anschlußpodeste 2, die hier mittels einer Randüberhöhung 6 strukturiert ausgebildet ist, so daß eine Verzahnung der Oberfläche der Anschlußpodeste 2 mit dem Leitbahnstrukturmaterial erreicht wird. Dabei wird die Anpreßkraft, mit der Halbleiterchip auf die Leitbahnstruktur 3 gepreßt wird, so eingestellt, daß die auf der Aluminiumleitbahnstruktur 3 ausgebildete Oxidschicht mit Sicherheit in einem ausreichenden Maße aufgebrochen wird, so daß der Übergangswiderstand klein gehalten werden kann. Es kann ein metallischer Kontakt mittels Kaltpreßschweißverbindung erreicht werden.

In der Figur ist weiter erkennbar, daß andere alternative Strukturierungsformen der Anschlußpodeste, außer der bereits erwähnten Randüberhöhung 6, wie zusätzlich die beispielhaft dargestellte Keil-, Kegel- oder Pyramidenform 7, Verwendung finden können. Im Nachgang hierzu wurde der Klebstoff 5 ausgehärtet, wobei zur Beschleunigung eine Energiezufuhr erfolgen kann. Während dieses Prozesses verringert sich das Volumen des aufgebrachten Klebstoffes 5 und es wird eine innige und mit einer Vorspannung behaftete Zugkraft zwischen Halbleiterchip 1 und Substratoberfläche bzw. Leitbahnstrukturoberfläche erreicht, die eine dauerhafte Verbindung sichert.

Nachfolgend sollen einige Beispiele für die stromlose Abscheidung von Palladium bzw. Palladiumlegierungen genannt werden:

### Beispiel 1

Zur Beschichtung wurde ein Siliziumwafer mit integrierten Schaltkreisen verwendet, die mit einer Passivierungsschicht aus Phosphorsilikatglas und Siliziumnitrid abgedeckt waren. In den Öffnungen der Passivierung waren die Anschlußpodeste aus 0,9 µm dickem AlSi1 mit lateralen Abmessungen von 95 x 95 µm² freigelegt. Der Wafer wurde zunächst in einer tensidhaltigen wäßrigen Lösung 2 min gereinigt und benetzt und danach durch 30 s Tauchen in Phosphorsäure von 50 Masse-% vorbehandelt. Danach erfolgte eine Behandlung in einer alkalischen, handelsüblichen Zinkatlösung für 40 s sowie das Abätzen der entstandenen Zinkschicht durch 5 s Tauchen in Salpetersäure von 45 Masse-%. Nach einer Wiederholung der Zinkatbehandlung mit einer Dauer von 60 s wurde der Wafer in den Elektrolyt für die stromlose Metallisierung eingetaucht. Dieser enthielt 0,01 mol/l Pd²⁺, 0,015 mol/l Ni²⁺, 0,12 mol/l Ethylendiamin, 0,01 mol/l α-Aminopropionsäure, 0,06 mol/l Natrium-Hypophosphit, 5 x 10⁻⁵ mol/l Pb²⁺ und ein nichtionisches Tensid auf der Grundlage von Fluoralkyl-polyethoxylat in einer Konzentration, die zu einer Absenkung der Oberflächenspannung bei 20 °C auf 25 bis 30 mN/m führte. Der pH wurde auf 8,3 eingestellt. Die Abscheidung wurde bei 70 °C vorgenommen. Nach einer Stunde betrug die Dicke der abgeschiedenen Legierungsschicht 4,12 µm, nach 2 Stunden von 7,9 µm. Sie hatte die Zusammensetzung Pd₈₅Ni₈P₇. Der Elektrolyt zeigte bei weiteren Abscheidungen bis zur Ausarbeitung von 35 % des Pd-Anteils keine Zersetzungserscheinungen. Die Rate sank bei der genannten Ausarbeitung auf 3,22 µm/h ab. Nach Aufbesserungen konnte der Elektrolyt stabil weiter betrieben werden, bis der gesamte Pd-Umsatz das 2,8-fache des ursprünglich eingesetzten Pd betrug, entsprechend einem sogenannten PD-turnover von 2,8. Danach verringerte sich die Abscheiderate auf einen unwirtschaftlichen Wert. Alle vorstehend beschriebenen Teilschritte, bei denen keine Temperaturangaben gemacht wurden, erfolgten bei Zimmertemperatur. Zwischen den einzelnen Schritten wurde jeweils mit entionisiertem, filtriertem Wasser gespült.

Die abgeschiedene Legierungsschicht zeigte eine matt graue, im Mikroskop dichte Oberfläche, die mit Knollen von ca. 0,3 bis 0,8 µm Durchmesser bedeckt war. Die beschichteten Anschlußpodeste ließen sich auch nach einer Lagerung an trockener Luft ohne Flußmittel mit flüssigem Lot der Zusammensetzung Sn₆₀Pb₄₀ bei 220 °C problemlos benetzen, unter Verwendung von milden Flußmitteln nach Lagerzeiten bis zu einem Jahr. Auch aufgetragene Lot-Druckpaste benetzte nach derselben Lagerdauer die Anschlußpodeste beim Aufschmelzen noch vollständig. Versuche mit siebdrucktechnisch aufgebrachten Hügeln aus zwei verschiedenen handelsüblichen Leitklebern A und B ergaben Übergangswiderstände von 6 bzw. 4 mΩ/mm² (zum Vergleich ergab eine reine Goldoberfläche mit denselben Klebern jeweils 3mΩ/mm²). Temperaturschock-Auslagerung (T1 = 125 °C, T2 = -55 °C, t = min) führte nach 1000 Zyklen beim Kleber A zu einem Anstieg auf 32 mΩ/mm² (bei Gold auf 21 mΩ/mm²). Die Haftfestigkeit lag höher als die Materialfestigkeit; es kam beim Abscheren zur Zerstörung des Leitkleberhügels. Die Beständigkeit gegenüber der Umsetzung mit Lotbestandteilen wurde am Beispiel des Zinns in einem beschleunigten Test ermittelt. Dazu wurde auf Proben mit mehreren µm der Pd-Legierung galvanisch eine Zinnschicht von ca. 5 µm Dicke aufgebracht, deren Masse durch die aufgewendete Ladung exakt bestimmt wurde und das Schichtsystem bei 200 °C, also deutlich über der mit zinnhaltigen Loten zu erwartenden Arbeitstemperatur, unterschiedliche Zeiten gelagert. Die Umsetzung des Zinns zu intermetallischer Phase wurde danach durch selektive coulometrische Messung der verbliebenen Zinnmasse ermittelt und der Anschaulichkeit halber in µm Zinndicke angegeben. Der Vergleich mit ebenfalls stromlos abgeschiedenen aber unlegierten Schichten der Zusammensetzung PdP₈ und NiP₁₀ zeigt in Figur 1 deutlich die unerwartet hohe Wirkung einer kleineren Nickelbeimischung. Noch deutlicher belegt wird diese drastische Wirkung des Ni anhand des linearen Anstiegs des Zinnumsatzes, der bei PdP₈ und NiP₁₀ von Anfang an und bei der Legierung nach einer kurzen Einschwingphase erkennbar war. Die Anstiege für die linearen Bereiche der Kurven aus Figur 1 betrugen:

| | | | |
|---|---|---|---|
| PdP₈ | 1,201 µm/min | gesetzt als | 100,0% |
| Pd₈₅Ni₈P₇ | 0,054 µm/min | entsprechend | 4,5% |
| NiP₁₀ | 0,016 µm/min | entsprechend | 1,4% |

### Beispiel 2

Das Beispiel 2 entspricht dem Beispiel 1, jedoch wurden bei der Herstellung des Elektrolyten 0,05 mol/l Pd²⁺ und 0,03 mol/l Ni²⁺ verwendet. Die Abscheiderate betrug 3,25 µm/h, die Zusammensetzung der Metallschicht entsprach Pd₇₁Ni₂₂P₇. Der Elektrolyt konnte bis zu einem Metall-turnover von 3,5 verwendet werden. Die Werte für die Haftfestigkeit und den Übergangswiderstand kamen denen aus Beispiel 1 nahe. Eine zuverlässige Lötfähigkeit konnte bei Verwendung von Flußmittel erreicht werden. Der lineare Anstieg in der Umsetzung mit Zinn betrug 0,027 µm/h, entsprechend 2,3 % des PdP₈-Wertes.

### Beispiel 3

Das Beispiel 3 entspricht dem Beispiel 1, jedoch wurde bei der Herstellung des Elektrolyten anstelle des Nickels Cobalt in der gleichen Konzentration verwendet. Die Abscheiderate betrug 2,85 µm/h, die Zusammensetzung der Metallschicht entsprach Pd₈₈Co₄P₈. Der Elektrolyt konnte bis zu einem Metall-turnover von 1,2 verwendet werden. Die Werte für die Lötfähigkeit, die Haftfestigkeit und den Übergangswiderstand kamen denen aus Beispiel 1 nahe, der lineare Anstieg in der Umsetzung mit Zinn betrug 0,092 µm/h, entsprechend 7,7% des PdP₈-Wertes.

### Beispiel 4

Das Beispiel 4 entspricht dem Beispiel 1, jedoch wurden bei der Herstellung des Elektrolyten Nickel und Cobalt in gleichen moralen Konzentrationen verwendet, so daß ihre Summe wieder 0,015 mol/l betrug. Die Abscheiderate erreichte 3,55 µm/h, die Zusammensetzung der Metallschicht entsprach Pd₈₇Ni₄Co₂P₇. Der Elektrolyt konnte bis zu einem Metall-turnover von 1,5 verwendet werden. Die Werte für die Lötfähigkeit, die Haftfestigkeit und den Übergangswiderstand kamen denen aus Beispiel 1 nahe, der lineare Anstieg in der Umsetzung mit Zinn betrug 0,048 µm/h, entsprechend 4,0% des PdP₈-Wertes.

### Beispiel 5

Das Beispiel 5 entspricht dem Beispiel 1, jedoch wurde der Elektrolyt auf pH 9,5 eingestellt. Die Abscheiderate erreichte 4,85 µm/h, die Zusammensetzung der Metallschicht entsprach Pd₃₃Ni₇P₁₀. Der Elektrolyt konnte bis zu einem Metall-turnover von 1,7 verwendet werden. Die Werte für die Lötfähigkeit, die Haftfestigkeit und den Übergangswiderstand kamen denen aus Beispiel 1 nahe, der lineare Anstieg in der Umsetzung mit Zinn betrug 0,044 µm/h, entsprechend 3,7% des PdP₈-Wertes.

### Beispiel 6

Das Beispiel 6 entspricht dem Beispiel 1, jedoch wurde bei der Herstellung des Elektrolyten anstelle der α-Aminopropionsäure Nitrilotriessigsäure N(CH₂COOH)₃ in derselben molaren Konzentration verwendet. Die Abscheiderate erreichte 3,95 µm/h, die Zusammensetzung der Metallschicht entsprach Pd₈₆Ni₇P₇. Der Elektrolyt konnte bis zu einem Metall-turnover von 2,3 verwendet werden. Die Werte für die Lötfähigkeit, die Haftfestigkeit und den Übergangswiderstand kamen denen aus Beispiel 1 nahe, der lineare Anstieg in der Umsetzung mit Zinn betrug 0,57 µm/h, entsprechend 4,8% des PdP₈-Wertes.

### Beispiel 7

Das Beispiel 7 entspricht dem Beispiel 1, jedoch wurden bei der Herstellung des Elektrolyten keine Amine mit α- oder β-ständigen Carboxyl- oder Carbonylgruppen verwendet. Die anfängliche Abscheiderate erreichte 5,66 µm/h, die Zusammensetzung der Metallschicht entsprach Pd₈₀Ni₁₃P₇. Der Elektrolyt konnte nur über einen Zeitraum von 45 min verwendet werden und zeigte danach beginnende Zersetzung. Die Werte für die Lötfähigkeit, die Haftfestigkeit, den Übergangswiderstand und die Umsetzung mit Zinn wurden nicht bestimmt.

### Beispiel 8

Das Beispiel 8 entspricht dem Beispiel 1, jedoch wurden bei der Herstellung des Elektrolyten 0,1 mol/l Dimethylaminoboran anstelle des Hypophosphits verwendet. Der Elektrolyt konnte nur unterhalb von 60 °C stabil betrieben werden. Die Abscheiderate betrug bei 58 °C 1,75 µm/h, die Zusammensetzung der Metallschicht entsprach Pd₉₂Ni₇B₁. Der Elektrolyt konnte bis zu einem Metall-turnover von 0,9 verwendet werden. Die Werte für die Haftfestigkeit und den Übergangswiderstand kamen denen aus Beispiel 1 nahe. Eine zuverlässige Lötfähigkeit konnte bis zu 12 Tagen nach der Beschichtung bei Lagerung an trockener Luft ohne Verwendung von Flußmittel erreicht werden. Der lineare Anstieg in der Umsetzung mit Zinn betrug 0,137 µm/h, entsprechend 11,4% des PdP₈-Wertes.

Bei allen Beispielen kann aber auch auf die Zugabe der Nickel- bzw. Cobaltverbindung verzichtet werden und reines Palladium stromlos abgeschieden werden.

## Patentansprüche

1. Verfahren zur Herstellung elektrisch leitender Verbindungen zwischen einzelnen Kontakten elektronischer Bauelemente (1) mit auf einem Substrat (4) ausgebildeter elektrisch leitender Leitbahnstruktur (3), bei dem
- an den Kontakten elektronischer Bauelemente (1) durch stromlose Abscheidung, überwiegend aus Palladium bestehende Anschlußpodeste (2) ausgebildet werden, die erhaben über die Bauteilgrundfläche hervorstehen;
- die Anschlußpodeste (2) unmittelbar auf die Leitbahnstruktur (3) mit einer Kraft auf die Leitbahnstruktur gepreßt wird, die ausreicht, um eine auf der Oberfläche der Leitbahnstruktur (3) ausgebildete Oxid- oder eine organische Schutzschicht aufzubrechen und
das/die elektronische(n) Bauelement(e) (1) mit dem Substrat (4) mittels eines/einer in Folge einer Volumenverringerung eine Druck- und/oder eine Zugkraft ausübenden Stoffes (5) oder einer Polymerfolie dauerhaft verbunden werden.

2. Verfahren nach Anspruch 1,
**dadurch gekennzeichnet, daß** die unmittelbar mit der Oberfläche der Leitbahnstruktur (3) in Kontakt stehende Oberfläche der Anschlußpodeste (2) strukturiert wird.

3. Verfahren nach Anspruch 2,
**dadurch gekennzeichnet, daß** die Oberfläche der Anschlußpodeste (2) mit einer Rauhtiefe von mindestens 5 µm strukturiert wird.

4. Verfahren nach einem der Ansprüche 1 bis 3,
**dadurch gekennzeichnet, daß** zumindest im Bereich der auszubildenden elektrisch leitenden Verbindung zwischen Anschlußpodest(en) (2) und Leitbahnstruktur (3) ein Klebstoff, aus einem Stoff oder Stoffgemisch, dessen Volumen sich beim Aushärten verringert, aufgebracht und durch diesen der/die Anschlußpodest(e) (2) auf die Leitbahnstruktur (3) gepreßt wird/werden.

5. Verfahren nach einem der Ansprüche 1 bis 4,
**dadurch gekennzeichnet, daß** eine Leitbahnstruktur (3) aus einem Metall und/oder einer elekfrisch leitenden Paste verwendet wird.

6. Verfahren nach einem der Ansprüche 1 bis 5,
**dadurch gekennzeichnet, daß** ein ebenes flächiges Element als Substrat (4) verwendet wird.

7. Verfahren nach einem der Ansprüche 1 bis 3, 5 oder 6, **dadurch gekennzeichnet, daß** die gesamte Oberfläche, des mit mindestens einem elektronischen Bauelement (1) kontaktierten Substrates (4) mit einer polymeren Schrumpffolie abgedeckt wird.

8. Verfahren nach einem der Ansprüche 1 bis 7,
**dadurch gekennzeichnet, daß** eine als Antenne wirkende Struktur (3) verwendet wird.

9. Verfahren nach einem der Ansprüche 1 bis 8,
**dadurch gekennzeichnet, daß** ein Halbleiterchip als elektronisches Bauelement (1) verwendet wird.

10. Verfahren nach einem der Ansprüche 1 bis 9,
**dadurch gekennzeichnet, daß** die stromlose Abscheidung von Palladium in einem wäßrigen Elektrolyten, indem eine Palladiumverbindung in einer Konzentration von 0,005 bis 0,15 mol/l, ein Reduktionsmittel für Palladiumionen und ein Komplexbildner enthalten sind, druchgeführt werden.

11. Verfahren nach einem der Ansprüche 1 bis 10,
**dadurch gekennzeichnet, daß** im wäßrigen Elektrolyten zusätzlich Nickel- und/oder Cobaltverbindungen in gelöster Form enthalten sind.

12. Verfahren nach einem der Ansprüche 1 bis 11,
**dadurch gekennzeichnet, daß** im Elektrolyten als Komplexbildner unsubstituierte Amine und ein oder mehrere in Wasser lösliche Amine mit α- oder β-ständigen Carboxyl- oder Carbonylgruppen in einer Gesamtkonzentration von 0,001 bis 0,8 mol/l enthalten sind.

13. Verfahren nach einem der Ansprüche 1 bis 12,
**dadurch gekennzeichnet, daß** im Elektrolyten lösliche Mono-, Di- oder Triamine oder höhere Amine einzeln oder in Gemischen, mit.einer Gesamtkonzentration von 0,05 bis 2 mol/l enthalten sind.

14. Verfahren nach einem der Ansprüche 1 bis 13,
**dadurch gekennzeichnet, daß** als Reduktionsmittel Verbindungen aus der Gruppe der Hypophosphorsäure, der Borhydride, der Aldehyde oder der Methansaure oder deren Derivate der genannten Verbindungen enthalten sind.

15. Verfahren nach einem der Ansprüche 1 bis 14,
**dadurch gekennzeichnet, daß** im Elektrolyten Netzmittel in einer Konzentration von 0,001 bis 0,1 Masse-% enthalten sind.

16. Verfahren nach einem der Ansprüche 1 bis 15,
**dadurch gekennzeichnet, daß** im Elektrolyten Stabilisatoren in einer Konzentration von 10 x 10⁻⁵ bis 3 x 10⁻² mol/l enthalten sind.

17. Verfahren nach Anspruch 16,
**dadurch gekennzeichnet, daß** als Stabilisatoren lösliche Schwermetallverbindungen aus der Gruppe der Metalle Kupfer, Thallium, Wismut, Antimon, Blei oder Indium enthalten sind.

18. Verfahren nach einem der Ansprüche 1 bis 17,
**dadurch gekennzeichnet, daß** im Elektrolyten ein pH-Wert zwischen 4 und 10 eingestellt wird.

19. Verfahren nach einem der Ansprüche 1 bis 18,
**dadurch gekennzeichnet, daß** die stromlose Abscheidung bei Temperaturen im Bereich von 40 bis 95 °C durchgeführt wird.

20. Verfahren nach einem der Ansprüche 1 bis 19,
**dadurch gekennzeichnet, daß** im wäßrigen Elektrolyten 0,005 bis 0,1 mol/l einer Palladiumverbindung in gelöster Form, 0,05 bis 0,2 mol/l gelöste Nickel- und/oder Cobaltverbindung in gelöster Form, 0,05 bis 2 mol/l gelöste Mono-, Di- oder Triamine oder höhere Amine einzeln oder Gemische davon, 0,001 bis 0,8 mol/l gelöste Amine mit α- oder β-ständigen Carboxyl- oder Carbonylgruppen, bis zu maximal 0,3 mol/l eines Reduktionsmittels, Stabilisatoren und Netzmittel enthalten sind.

## Claims

1. Method for producing electrically conductive connections between individual contacts of electronic components (1) with a conductive track structure (3) that is electrically conductive and is formed on a substrate (4), in which
- connecting pedestals (2) predominantly comprising palladium are formed at the contacts of electronic components (1) by electroless deposition, said connecting pedestals projecting in elevated fashion over the base area of the device;
- the connecting pedestals (2) are pressed directly onto the conductive track structure (3) with a force onto the conductive track structure that suffices to break up an oxide or an organic protective layer formed on the surface of the conductive track structure (3), and
the electronic component(s) (1) is/are permanently connected to the substrate (4) by means of a substance (5) or a polymer film that exerts a compressive and/or tensile force on account of a reduction of volume.

2. Method according to Claim 1,
**characterized in that** the surface of the connecting pedestals (2) which is directly in contact with the surface of the conductive track structure (3) is patterned.

3. Method according to Claim 2,
**characterized in that** the surface of the connecting pedestals (2) is patterned with a roughness height of at least 5 µm.

4. Method according to one of Claims 1 to 3,
**characterized in that** an adhesive, comprising a substance or substance mixture, the volume of which decreases in the course of curing, is applied at least in the region of the electrically conductive connection to be formed between connecting pedestal(s) (2) and conductive track structure (3) and the connecting pedestal(s) (2) is/are pressed onto the conductive track structure (3) by means of said adhesive.

5. Method according to one of Claims 1 to 4,
**characterized in that** a conductive track structure (3) made of a metal and/or an electrically conductive paste is used.

6. Method according to one of Claims 1 to 5,
**characterized in that** a planar areal element is used as the substrate (4).

7. Method according to one of Claims 1 to 3, 5 or 6,
**characterized in that** the entire surface of the substrate (4) contact-connected to at least one electronic component (1) is covered with a polymeric shrink film.

8. Method according to one of Claims 1 to 7,
**characterized in that** a structure (3) acting as an antenna is used.

9. Method according to one of Claims 1 to 8,
**characterized in that** a semiconductor chip is used as the electronic component (1).

10. Method according to one of Claims 1 to 9,
**characterized in that** the electroless deposition of palladium are carried out in an aqueous electrolyte containing a palladium compound in a concentration of 0.005 to 0.15 mol/l, a reducing agent for palladium ions and a complexing agent.

11. Method according to one of Claims 1 to 10,
**characterized in that** the aqueous electrolyte additionally contains nickel and/or cobalt compounds in dissolved form.

12. Method according to one of Claims 1 to 11,
**characterized in that** the electrolyte contains, as complexing agents, unsubstituted amines and one or more water-soluble amines having α- or β-terminal carboxyl or carbonyl groups in an overall concentration of 0.001 to 0.8 mol/l.

13. Method according to one of Claims 1 to 12,
**characterized in that** the electrolyte contains soluble monoamines, diamines or triamines or higher amines individually or in mixtures, with an overall concentration of 0.05 to 2 mol/l.

14. Method according to one of Claims 1 to 13,
**characterized in that** compounds from the group consisting of hypophosphoric acid, the boron hydrides, the aldehydes or methanoic acid or derivates of the aforementioned compounds thereof are contained as reducing agents.

15. Method according to one of Claims 1 to 14,
**characterized in that** the electrolyte contains wetting agents in a concentration of 0.001 to 0.1 mass %.

16. Method according to one of Claims 1 to 15,
**characterized in that** the electrolyte contains stabilizers in a concentration of 10 x 10⁻⁵ to 3 x 10⁻² mol/l.

17. Method according to Claim 16,
**characterized in that** soluble heavy metal compounds from the group consisting of the metals copper, thallium, bismuth, antimony, lead or indium are contained as stabilizers.

18. Method according to one of Claims 1 to 17,
**characterized in that** a pH value of between 4 and 10 is set in the electrolyte.

19. Method according to one of Claims 1 to 18,
**characterized in that** the electroless deposition is carried out at temperatures in the range of 40 to 95°C.

20. Method according to one of Claims 1 to 19,
**characterized in that** the aqueous electrolyte contains 0.005 to 0.1 mol/l of a palladium compound in dissolved form, 0.05 to 0.2 mol/l of dissolved nickel and/or cobalt compound in dissolved form, 0.05 to 2 mol/l of dissolved monoamines, diamines or triamines or higher amines individually or mixtures thereof, 0.001 to 0.8 mol/l of dissolved amines with α- or β-terminal carboxyl or carbonyl groups, up to a maximum of 0.3 mol/l of a reducing agent, stabilizers and wetting agents.

## Revendications

1. Procédé de réalisation de liaisons électroconductrices entre différents contacts de composants électroniques (1) avec une structure de piste conductrice électroconductrice conformée sur un substrat (4), dans lequel
- sur les contacts des composants électroniques (1) sont conformés par dépôt sans courant des plots de raccordements (2) constitués principalement de palladium qui font saillie en relief au-delà de la surface de base du composant,
- les plots de raccordement (2) sont pressés directement sur la structure de piste conductrice (3) avec une force sur la structure de piste conductrice qui suffit pour percer une couche d'oxyde ou une couche de protection organique conformée sur la surface de la structure de piste conductrice (3) et
- le(s) composant(s) électronique(s) (1) sont reliés de manière permanente au substrat (4) au moyen d'une matière (5) ou d'un film polymère exerçant une force de pression et / ou une force de traction à la suite d'une diminution de volume.

2. Procédé selon la revendication 1, **caractérisé en ce que** la surface des plots de raccordement (2) qui est directement en contact avec la surface de la structure de piste conductrice (3) est structurée.

3. Procédé selon la revendication 2, **caractérisé en ce que** la surface des plots de raccordement (2) est structurée avec une profondeur de rugosité d'au moins 5 µm.

4. Procédé selon une des revendications 1 à 3, **caractérisé en ce qu'**au moins dans la région de la liaison électroconductrice à construire, un adhésif constitué d'une matière ou d'un mélange de matières, dont le volume se réduit lors du durcissement, est appliqué entre le(s) plot(s) de raccordement (2) et la structure de piste conductrice (3) et le(s) plot(s) de raccordement (2) est (sont) pressé(s) par celui-ci sur la structure de piste conductrice (3).

5. Procédé selon une des revendications 1 à 4, **caractérisé en ce qu'**une structure de piste conductrice (3) en métal et / ou en pâte électroconductrice est utilisée.

6. Procédé selon une des revendications 1 à 5, **caractérisé en ce qu'**un élément de surface plate est utilisé comme substrat (4).

7. Procédé selon une des revendications 1 à 3, 5 ou 6, **caractérisé en ce que** la surface totale du substrat (4) mis en contact avec au moins un composant électronique (1) est recouverte d'un film polymère rétractable.

8. Procédé selon une des revendications 1 à 7, **caractérisé en ce qu'**une structure (3) agissant comme antenne est utilisée.

9. Procédé selon une des revendications 1 à 8, **caractérisé en ce qu'**une puce semi-conductrice est utilisée comme composant électronique (1).

10. Procédé selon une des revendications 1 à 9, **caractérisé en ce que** le dépôt sans courant de palladium est réalisé dans un électrolyte aqueux dans lequel sont contenus un composé de palladium dans une concentration de 0,005 à 0,15 mole / l, un agent réducteur pour les ions de palladium et un agent complexant.

11. Procédé selon une des revendications 1 à 10, **caractérisé en ce qu'**en outre, des composés de nickel et / ou de cobalt sont contenus sous forme dissoute dans l'électrolyte aqueux.

12. Procédé selon une des revendications 1 à 11, **caractérisé en ce que** des amines non substituées et une ou plusieurs amines solubles dans l'eau avec des groupes carboxyle ou carbonyle en position α et β dans une concentration totale de 0,001 à 0,8 mole / l sont contenues comme agent complexant dans l'électrolyte.

13. Procédé selon une des revendications 1 à 12, **caractérisé en ce que** des mono, di ou tri-amines ou des amines supérieures solubles, seules ou en mélanges, avec une concentration totale de 0,05 à 2 moles / l sont contenues dans l'électrolyte.

14. Procédé selon une des revendications 1 à 13, **caractérisé en ce que** des composés du groupe composé par l'acide hypophosphorique, l'hydrure de bore, l'aldéhyde ou l'acide méthanoique ou des dérivés des composés cités sont contenus comme agent réducteur.

15. Procédé selon une des revendications 1 à 14, **caractérisé en ce que** des agents mouillants dans une concentration de 0,001 à 0,1 % en masse sont contenus dans l'électrolyte.

16. Procédé selon une des revendications 1 à 15, **caractérisé en ce que** des stabilisants dans une concentration de 10 x 10⁻⁵ à 3 x 10⁻² moles / l sont contenus dans l'électrolyte.

17. Procédé selon la revendication 16, **caractérisé en ce que** des composés solubles de métaux lourds du groupe des métaux composé par le cuivre, le thallium, le bismuth, l'antimoine, le plomb ou l'indium sont contenus comme stabilisants.

18. Procédé selon une des revendications 1 à 17, **caractérisé en ce qu'**une valeur de pH entre 4 et 10 est réglée dans l'électrolyte.

19. Procédé selon une des revendications 1 à 18, **caractérisé en ce que** le dépôt sans courant est réalisé dans la plage de 40 à 95°C.

20. Procédé selon une des revendications 1 à 19, **caractérisé en ce que** 0,005 à 0,1 mole / l d'un composé de palladium sous forme dissoute, 0,05 à 0,2 mole / l de composé de nickel et / ou de cobalt sous forme dissoute, 0,05 à 2 moles / l de mono, di ou tri-amine ou d'amines supérieures, seules ou en mélanges, 0,001 à 0,8 mole / l d'amines dissoutes comprenant des groupes carboxyle ou carbonyle en position α ou β, jusqu'à un maximum de 0,3 mole / l d'un agent réducteur, des stabilisants et des agents mouillants sont contenus dans l'électrolyte aqueux.
